(19) Europäisches Patentamt
European Patent Office
Office européen des brevets

(11) **EP 2 974 534 B1**

(12) # EUROPEAN PATENT SPECIFICATION

(45) Date of publication and mention
of the grant of the patent:
**31.01.2018 Bulletin 2018/05**

(51) Int Cl.:
***G02F 1/1333*** *(2006.01)*     ***G09F 9/00*** *(2006.01)*
***H01L 27/12*** *(2006.01)*

(21) Application number: **14772973.5**

(22) Date of filing: **10.03.2014**

(86) International application number:
**PCT/US2014/022340**

(87) International publication number:
**WO 2014/159170 (02.10.2014 Gazette 2014/40)**

(54) **METHODS OF PROCESSING ELECTRONIC DEVICES**

VERFAHREN ZUR BEARBEITUNG ELEKTRONISCHER VORRICHTUNGEN

PROCÉDÉS DE TRAITEMENT DE DISPOSITIFS ÉLECTRONIQUES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.03.2013 US 201361781872 P**

(43) Date of publication of application:
**20.01.2016 Bulletin 2016/03**

(73) Proprietor: **Corning Incorporated
Corning, New York 14831 (US)**

(72) Inventors:
• **BOWDEN, Bradley Frederick
Corning, New York 14830 (US)**
• **ELLISON, Adam James
Corning, New York 14830 (US)**
• **WEEKS, Wendell Porter
Corning, New York 14830 (US)**

(74) Representative: **Greene, Simon Kenneth
Elkington and Fife LLP
Prospect House
8 Pembroke Road
Sevenoaks, Kent TN13 1XR (GB)**

(56) References cited:
**WO-A1-2005/048669     WO-A2-2010/129459
KR-A- 20120 063 716     KR-A- 20120 130 966
KR-A- 20130 024 098     US-A1- 2010 163 878
US-A1- 2011 048 611**

**Description**

**BACKGROUND**

Field of the invention.

The present invention is directed to methods of processing electronic devices and, more particularly, methods of processing electronic devices using thin sheets and carriers.

Technical Background.

Flexible substrates offer the promise of cheaper devices using roll-to-roll processing, and the potential to make thinner, lighter, more flexible and durable displays. However, the technology, equipment, and processes required for roll-to-roll processing of high quality displays are not yet fully developed. Since panel makers have already heavily invested in toolsets to process large sheets of glass, laminating a flexible substrate to a carrier and making display devices by a sheet-to-sheet process offers a shorter term solution to develop the value proposition of thinner, lighter, and more flexible displays. The electronic devices are made on the flexible substrate, as it is supported by the carrier so as to provide sufficient rigidity to the flexible substrate during processing. After the desired electronic devices are produced on the flexible substrate, the flexible substrate (either in whole, or in part) is removed from the carrier.

The carrier is typically a display-grade glass substrate, which can be costly. Some manners of bonding the flexible substrate to the carrier allow the carrier to remain intact after the flexible substrate is debonded therefrom. See, for example, US Provisional Patent Application Serial Nos. 61/736887, 61/736862, and 61/736871, each filed on 13 December 2012 (hereinafter "the December 13 Applications"). Other manners of bonding the flexible substrate to the carrier provide regions of permanent bonding between the flexible substrate and the carrier. See, for example, PCT Patent Application Serial No. PCT/US13/25035, filed on 07 February 2013 (hereinafter "the February 07 Application"). In either event, it is desired to be able to reuse the carrier so as to reduce processing costs. WO 2005/048669 discloses a method for processing a flexible substrate comprising fixing the substrate to a rigid plate using an adhesive elastomer. WO 2010/129459 discloses bonding a thin glass sheet to a carrier by an elastomer.

**SUMMARY**

Electronic devices, e.g. thin film transistors (TFTs), are fabricated onto a substrate in multiple steps. In recent years, the space or pitch between devices on a substrate has been getting smaller and smaller, requiring a tighter and tighter alignment tolerance between the material applied in one step and that applied in a subsequent step. The ability to produce electronic devices consistently with such a tight alignment requirement gives rise to the necessity of having substrates that behave in a similar manner from one to the next, through the process, i.e., each substrate will undergo a similar dimensional change from start to finish of the device making process.

More specifically, for example, thin film transistor (TFT) arrays and color filters (CF) for liquid crystal display (LCD) television panels are fabricated on flat glass substrates. Amorphous silicon (a-Si) TFT and CF fabrication processes require multiple thermal cycles at temperatures up to -350 °C for the former and ~250 °C for the latter. At these temperatures display glass substrates undergo compaction on the order of up to 4 ppm (for fusion formed glass) for practical treatment times. Fabricators of CF and TFT substrates can compensate their exposure magnifications at least up to 10 ppm so the typical compaction magnitude of a display glass substrate in either process is not typically an issue. However, if the compaction is non-uniform within the glass substrate or varies from piece to piece, exposure compensation may be insufficient to provide proper alignment of features deposited in successive thermal cycles. Total pitch error is a term assigned to LCD panels that malfunction as a result of misalignment of features within the CF or TFT substrates, or misalignment of the TFT relative to the CF plate. Typical total pitch error budgets are 4 $\mu$m and 6 $\mu$m for the TFT and CF respectively. Several emerging trends in the display market are resulting in tighter total pitch specifications and increased risk of total pitch error due to compaction:

- Factors driving tighter total pitch specifications include:

  ∘ Increased panel resolution for product differentiation;
  ∘ Increased aperture ratio for higher panel transmission; and
  ∘ Migration of smaller applications into larger size substrates for product mix flexibility.

- Factors driving increased risk of total pitch errors due to compaction include:

◦ Reduced inter process step pitch measurements and compensation recipe adjustments for higher manufacturing throughput;
◦ Decreased substrate thickness for thin lightweight panels;
◦ Increased Gen sizes for reduced cost of large size (> 40") displays.

The present inventors have found that when a glass carrier is reused as a carrier in the same process, the glass carrier compacts (or shrinks due at least in part to thermal influences). And, each time a glass carrier goes through the same time-temperature cycle, it compacts further, albeit to a somewhat lesser extent than the previous time through the cycle. Additionally, compaction of the carrier affects the compaction of the flexible glass coupled thereto, as well as the overall combined compaction of an article (carrier and flexible glass substrate combination). Thus, when attempting to reuse a carrier for subsequent flexible glass substrates, one article may, undesirably, undergo a different compaction than another depending upon the difference between times that the articles' carriers have been through the process.

Such differences in dimensional change between different articles going through the same device making process is undesirable, as it makes the exposure compensation process very difficult, at best, and perhaps unworkable. Yet it is very costly to simply throw away, or dispose of, the carrier after one trip through a device making process. Accordingly, the inventors have found that the carrier may advantageously be reused in a manner other than as a carrier in the same process. Instead, the carrier may be used as a substrate in its own right on which electronic devices may be made. In some instances, the carrier's compaction in one process may advantageously make it useable as a substrate in a higher-temperature process in which it would otherwise not have been usable because it would have undergone unacceptable dimensional change. In other instances, the carrier's compaction in one process may advantageously make it useable as a substrate on which electronic devices are formed in a lower temperature process wherein it will undergo much less dimensional change. Alternatively, after having went through a first process for forming electronic devices on a flexible glass substrate coupled thereto, the carrier may be used as a carrier for a second flexible glass substrate upon which different electronic devices will be made in a lower temperature (as compared to the first) process. Further yet, in some instances, the carrier may be used to carry multiple flexible glass substrates, wherein electronic devices are formed in turn on each of the substrates through subsequent processes, wherein passing through the prior process may advantageously make the next substrate better suited to undergo the next process.

Additional features and advantages will be set forth in the detailed description which follows, and in part will be readily apparent to those skilled in the art from the description or recognized by practicing the various aspects as exemplified in the written description and the appended drawings. It is to be understood that both the foregoing general description and the following detailed description are merely exemplary of the various aspects, and are intended to provide an overview or framework to understanding the nature and character of the invention as it is claimed.

The accompanying drawings are included to provide a further understanding of principles of the invention, and are incorporated in and constitute a part of this specification. The drawings illustrate one or more embodiment(s), and together with the description serve to explain, by way of example, principles and operation of the invention. It is to be understood that various features disclosed in this specification and in the drawings can be used in any and all combinations. By way of non-limiting example the various features may be combined with one another as set forth in the following aspects:

According to a first aspect, there is provided a method of processing electronic devices according to claim 1.

According to an embodiment the carrier is chemically strengthened prior to the second processing cycle, and further wherein the second device includes an anti-glare, anti-fingerprint, anti-smudge, or anti-microbial, film.

According to an embodiment, the method of processing electronic devices comprisies:

coupling the carrier to a second thin glass sheet to form a second article; and
subjecting the second article to a second processing cycle to form a second device on the second thin glass sheet, wherein after the second processing cycle the carrier QCOLED compaction value decreases $\leq 5\%$.

According to a fourth embodiment the first article comprises a second thin glass sheet coupled to the first thin glass sheet and to the carrier and the method further comprises; removing the first thin glass sheet from the first article so as to form a second article; and
subjecting the second article to a second processing cycle to form a second device on the second thin glass sheet.

According to an embodiment, there is provided the method of embodiment 4, wherein the carrier is dead-annealed.

According to a sixth embodiment, there is provided the method of aspect 4, wherein the carrier is dead-annealed prior to being coupled to the first or second thin glass sheet.

According to a seventh embodiment, there is provided the method of aspect 4, wherein the second thin glass sheet is located on the same side of the carrier as is the first thin glass sheet.

According to an eighth embodiment, there is provided the method of any one of aspects 1-7, wherein during the second processing cycle a maximum processing temperature used is less than that used during the first processing cycle.

According to a ninth embodiment, there is provided the method of any one of aspects 1-8, wherein the first processing cycle includes a maximum temperature in the range of greater than 450°C to ≤ 700°C.

According to a tenth embodiment, there is provided the method of aspect 9, wherein the second processing cycle includes a maximum temperature ≤ 450°C.

According to an eleventh embodiment, there is provided the method of aspect 9 or aspect 10, wherein the first device is a polycrystalline semiconductor device, a microcrystalline semiconductor device, a low temperature poly-silicon device, or a crystalline oxide TFT device.

According to a twelfth embodiment, there is provided the method of any one of aspects 1-8, wherein the first processing cycle includes a maximum temperature in the range of greater than 250°C to ≤ 450°C.

According to a thirteenth embodiment, there is provided the method of aspect 12, wherein the second processing cycle includes a maximum temperature ≤ 250°C.

According to a fourteenth embodiment, there is provided the method of aspect 12 or aspect 13, wherein the first device is an amorphous semiconductor device, an amorphous oxide TFT device, or an amorphous silicon LCD.

According to a fifteenth embodiment, there is provided the method of aspect 13 or 14, wherein the second device is a touch sensor, a transparent conductive material film, or a color filter.

According to a sixteenth embodiment, there is provided the method of any one of aspects 1-7, wherein the second processing cycle maximum temperature is greater than that in the first processing cycle.

According to a seventeenth embodiment, there is provided the method of aspect any one of aspects 1-7 or 16, wherein the first processing cycle includes a maximum temperature in the range of greater than 250°C to ≤450°C.

According to an eighteenth embodiment, there is provided the method of aspect 17, wherein the first device is an amorphous semiconductor device, an amorphous oxide TFT, or an amorphous silicon LCD device.

According to a nineteenth embodiment, there is provided the method of any one of aspects 16-18, wherein the second processing cycle maximum temperature is in the range of greater than 450°C to ≤ 700°C.

According to a twentieth embodiment there is provided the method of aspect 19, wherein the second device is a polycrystalline semiconductor device, a microcrystalline semiconductor device, a low temperature poly-silicon device, or a crystalline oxide TFT device..

According to a twenty first embodiment, there is provided the method of any one of aspects 1-20, wherein the carrier has a thickness of ≥ 200 microns.

According to a twenty second embodiment, there is provided the method of any one of aspects 1-21, wherein the thin glass sheet has a thickness of ≤ 300 microns.

. According to a twenty third embodiment, there is provided the method of any one of aspects 1-22, further comprising providing a protective layer on a side of the carrier opposite to that on which the thin glass sheet is located during processing.

According to a twenty fourth embodiment, there is provided the method of aspect 23, wherein the protective layer is one of a hard-coat layer and a thin glass sheet.

According to a twenty fifth embodiment, there is provided the method of any one of aspects 1-24, wherein the carrier is glass.

According to a twenty sixth embodiment, there is provided the method of any one of aspects 1-25, wherein the carrier has an area ≥ 0.1 square meter.

According to a twenty seventh embodiment, there is provided the method of any one of aspects 1-26, wherein the thin glass sheet has an area ≥ 0.1 square meter.

## BRIEF DESCRIPTION OF THE DRAWINGS

FIG. 1 is a side view of one embodiment of an article having a thin glass sheet coupled to a carrier.
FIG. 2 is an exploded view of the article shown in FIG. 1.
FIG. 3 is a time-temperature graph for a QCOLED compaction test.
FIG. 4 is a schematic view of scribe lines and node locations for measurements in the QCOLED compaction test of FIG. 3
FIG. 5 is a schematic process flow.
FIG. 6 is a side view of a second embodiment of an article having thin glass sheets coupled to a carrier.
FIG. 7 is a side view of a third embodiment of an article having a thin glass sheet coupled to a carrier.

**DETAILED DESCRIPTION**

In the following detailed description, for purposes of explanation and not limitation, example embodiments disclosing specific details are set forth to provide a thorough understanding of various principles of the present invention. However, it will be apparent to one having ordinary skill in the art, having had the benefit of the present disclosure, that the present invention may be practiced in other embodiments that depart from the specific details disclosed herein. Moreover, descriptions of well-known devices, methods and materials may be omitted so as not to obscure the description of various principles of the present invention. Finally, wherever applicable, like reference numerals refer to like elements.

Ranges can be expressed herein as from "about" one particular value, and/or to "about" another particular value. When such a range is expressed, another embodiment includes from the one particular value and/or to the other particular value. Similarly, when values are expressed as approximations, by use of the antecedent "about," it will be understood that the particular value forms another embodiment. It will be further understood that the endpoints of each of the ranges are significant both in relation to the other endpoint, and independently of the other endpoint.

Directional terms as used herein-for example up, down, right, left, front, back, top, bottom-are made only with reference to the figures as drawn and are not intended to imply absolute orientation.

Unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is no way intended that an order be inferred, in any respect. This holds for any possible non-express basis for interpretation, including: matters of logic with respect to arrangement of steps or operational flow; plain meaning derived from grammatical organization or punctuation; the number or type of embodiments described in the specification.

As used herein, the singular forms "a," "an" and "the" include plural referents unless the context clearly dictates otherwise. Thus, for example, reference to a "component" includes aspects having two or more such components, unless the context clearly indicates otherwise.

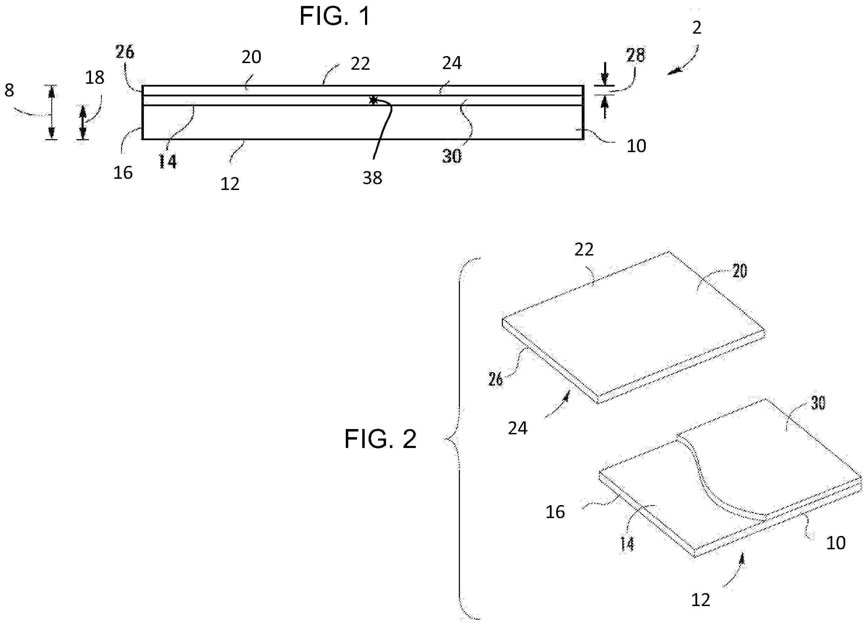

As shown in FIGS. 1 and 2, a glass article 2 has a thickness 8, and includes a carrier 10 having a thickness 18, a thin sheet 20 (i.e., one having a thickness of $\leq$ 300 microns, including but not limited to thicknesses of, for example, 10-50 microns, 50-100 microns, 100-150 microns, 150-300 microns, 300, 250, 200 190, 180, 170, 160, 150 140, 130, 120 110 100, 90, 80, 70, 60, 50, 40 30, 20, or 10, microns) having a thickness 28, and a coupling agent 30 having a thickness 38. The glass article 2 is designed to allow the processing of thin sheet 20 in equipment designed for thicker sheets (i.e., those on the order of $\geq$ .4mm, e.g., .4 mm, .5 mm, .6 mm, .7 mm, .8 mm, .9 mm, or 1.0 mm) although the thin sheet 20 itself is $\leq$ 300 microns. That is, the thickness 8, which is the sum of thicknesses 18, 28, and 38, is designed to be equivalent to that of the thicker sheet for which a piece of equipment-for example, equipment designed to dispose electronic device components onto substrate sheets-was designed to process. For example, if the processing equipment was designed for a 700 micron sheet, and the thin sheet had a thickness 28 of 300 microns, then thickness 18 would be selected as 400 microns, assuming that thickness 38 is negligible. That is, the coupling agent 30 is not shown to scale; instead, it is greatly exaggerated for sake of illustration only. Additionally, in FIG. 2, the coupling agent is shown in cut-away. In actuality, the coupling agent would be disposed over the bonding surface 14 so as to prevent permanent bonding between the thin sheet 20 and carrier 10 at least over the central area of overlap between the two, and preferably over the entire area of overlap between the thin sheet 20 and carrier 10. Typically, thickness 38 will be on the order of nanometers, for example 0.1 to 2.0, or up to 10 nm, and in some instances may be up to 100 nm. The thickness 38 may be measured by ellipsometer. Additionally, the presence of a coupling agent may be detected by surface chemistry analysis, for example by ToF Sims mass spectrometry. Accordingly, the contribution of thickness 38 to the article thickness 8 may be negligible and may be ignored in the calculation for determining a suitable thickness 18 of carrier 10 for processing a given thin sheet 20 having a thickness 28. However, to the extent that coupling agent 30 has any significant thickness 38, such may be accounted for in determining the thickness 18 of a carrier 10 for a given thickness 28 of thin sheet 20, and a given thickness for which the processing equipment was designed.

Carrier 10 has a first surface 12, a bonding surface 14, a perimeter 16, and thickness 18. Further, the carrier 10 may be of any suitable material including glass, for example. The carrier need not be glass, but instead can be ceramic, or glass-ceramic. If made of glass, carrier 10 may be of any suitable composition including alumino-silicate, boro-silicate, alumino-boro-silicate, soda-lime-silicate, and may be either alkali containing or alkali-free depending upon its ultimate application. Thickness 18 may be from about 0.2 to 3 mm, or greater, for example 0.2, 0.3, 0.4, 0.5, 0.6, 0.65, 0.7, 1.0, 2.0, or 3 mm, or greater, and will depend upon the thickness 28, and thickness 38 when such is non-negligible, as noted above. Additionally, the carrier 10 may be made of one layer, as shown, or multiple layers (including multiple thin sheets) that are bonded together. Further, the carrier may be of a wafer size or larger, for example, Gen 2, Gen 3, Gen 4, Gen 5, Gen 8 or larger (e.g., sheet sizes from 100 mm x 100 mm to 3 meters x 3 meters or greater).

The thin sheet 20 has a first surface 22, a bonding surface 24, a perimeter 26, and thickness 28. Perimeters 16 and 26 may be of any suitable shape, may be the same as one another, or may be different from one another. Further, the thin sheet 20 may be of any suitable material including glass, ceramic, or glass-ceramic, for example. When made of glass, thin sheet 20 may be of any suitable composition, including alumino-silicate, boro-silicate, alumino-boro-silicate, soda-lime-silicate, and may be either alkali containing or alkali free depending upon its ultimate application. The coefficient of thermal expansion of the thin sheet could be matched relatively closely with that of the carrier to prevent warping of the article during processing at elevated temperatures. The thickness 28 of the thin sheet 20 is 300 microns or less, as noted above. Further, the thin sheet may be of a wafer size or larger, for example, Gen 2, Gen 3, Gen 4, Gen 5, Gen 8 or larger (e.g., sheet sizes from 100 mm x 100 mm to 3 meters x 3 meters or greater).

The coupling agent 30 couples the thin sheet 20 with the carrier 10 so that they may go through a process together. Although the coupling agent 30 is shown as a solid layer between thin sheet 20 and carrier 10, such need not be the case. For example, the layer 30 may be on the order of 0.1 to 2 nm thick, and may not completely cover every bit of the bonding surface 14. For example, the coverage may be $\leq$ 100%, from 1% to 100%, from 10% to 100%, from 20% to 90%, or from 50% to 90%. In other embodiments, the layer 30 may be up to 10 nm thick, or in other embodiments even up to 100 nm thick. The coupling agent 30 may be considered to be disposed between the carrier 10 and thin sheet 20 even though it may not contact one or the other of the carrier 10 and thin sheet 20. In any event, an important aspect of the coupling agent 30 is that it allows the carrier 10 and the thin sheet 20 to be coupled to one another for electronic device processing onto the thin sheet 20, allows the thin sheet 20 to be removed from the carrier 10 after the electronic device processing, and is removable from the carrier after or along with the removal of thin sheet 20. The material and thickness of the coupling agent 30, as well as the treatment of the bonding surfaces 14, 24 prior to bonding, can be used to control the strength of the bond (energy of adhesion) between carrier 10 and thin sheet 20 as set forth in the December 13 Applications. Alternatively, the coupling agent 30 may be used to provide regions of permanent bonding between the flexible substrate and the carrier as in the February 7 application. In this latter case, when the coupling agent is used to create a permanent bond between the thin sheet 20 and carrier 10, it may be used only around the perimeter of the overlap area between the thin sheet 20 and carrier 10. Thus, the perimeter portion may be removed to provide separate thin sheet 20 and carrier 10. Although the carrier 10 will be somewhat smaller than the original carrier 10, such may be suitable for some applications and, in fact, the carrier 10 may be diced into smaller substrate sizes after removal of the thin sheet 20. For example, electronic devices may be processed onto the thin sheet of an article having a Gen 8 size. Then after removal of the thin sheet 20 and the devices thereon, the Gen 8 size carrier may have the regions of permanent bonding removed and be diced into multiple smaller Gen 2 size pieces for subsequent use as described below.

Compaction and the QCOLED compaction value / test

As noted above, when the carrier goes through a time-temperature cycle, it will compact, or shrink. As a practical matter, if the strain point of the glass is much greater than the process temperatures to be encountered (e.g., greater than about 200-300°C), compaction is minimal. The degree of compaction will depend upon the prior thermal history of the glass, and the type of time-temperature cycle which, in turn, depends upon the type of electronic devices being formed. For example, flat panel display (FPD) processing lines may include high temperature processing- wherein high temperature processing is processing at a temperature greater than 250°C, and may vary depending upon the type of device being made, for example, including temperatures up to about 450°C as in amorphous semiconductor processing (including amorphous silicon or amorphous oxide TFT (e.g., indium gallium zinc oxide (IGZO)) backplane processing for example), and including up to about 500-550°C as in crystalline semiconductor processing (including crystalline oxide TFT processing, for example), or up to about 600-650°C as is typical in polycrystalline or microcrystalline semiconductor processing including low temperature poly silicon (LTPS) processes, wherein "low temperature" associated with LTPS processes is low in comparison to solid phase crystallization that may take place around 750°C. Typical aSi TFT fabrication requires processing up to 320°C. Annealing at 400°C is used in oxide TFT processes, whereas crystallization and dopant activation steps over 600°C are used in LTPS processing. On the other end of the spectrum, lower temperature processing, for example, less than or equal to 250°C, may be used to form, for example, color filter devices, or touch sensor devices, including deposition of transparent conductive materials, for example ITO.

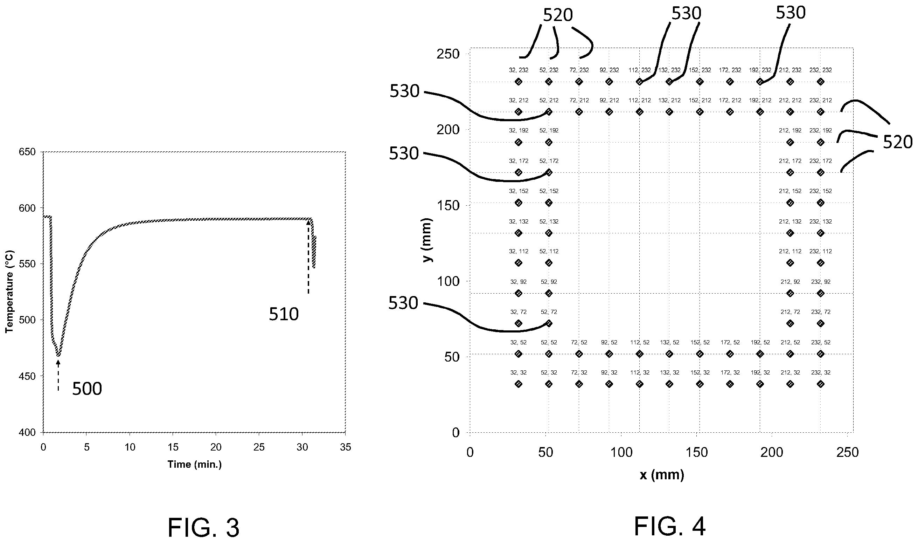

The stability of a sheet of glass undergoing such processing, including a carrier, a thin sheet, or an article, can be measured by a QCOLED test, which will be described with reference to FIGS. 3 and 4. In general, the lower the QCOLED compaction value, the less a sheet of glass will compact in a particular process.

The QCOLED thermal cycle is designed to distinguish differences in the compaction of glasses intended for polysilicon based AMOLED applications, but is also useful for determining the relative thermal stability of one substrate as compared to another. The compaction of typical polysilicon substrate glasses in the QCOLED cycle is greater than 25 ppm. Since the gauge noise is about 1 ppm, the QCOLED cycle is effective in distinguishing small differences in performance that would otherwise be difficult to identify using a typical multistep polysilicon manufacturing thermal cycle.

A measure of QCOLED compaction may be performed in the following manner, using test samples of 254 x 254 mm pieces.

The basic compaction measurement procedure is as follows:

1. scribe 11 lines 520 across the sample at 20 mm pitch in both the horizontal and vertical directions, see FIG. 4,

2. perform a "first look" to determine the initial location of 72 reference nodes 530 (located at the intersections associated the two outermost scribe lines on each edge of the sheet, see FIG. 4) relative to fiducial marks on the gauge,

3. heat treat the samples, wherein the samples are heat treated in a box furnace according to the thermal profile shown in FIG. 3. First, the furnace is preheated to slightly above 590 °C. The samples are then plunged into the furnace (see point 500 in the graph of FIG. 3) through a small slit in the front of the furnace. After thirty minutes the samples are quenched out (see point 510 in the graph of FIG. 3) of the furnace into ambient air. The total time the samples reside at the peak temperature 590 °C is about 18 minutes.

4. remeasure the locations of the 72 reference nodes, and

5. determine the compaction by averaging the displacement of all nodes relative to their initial position.

Regarding remeasurement of the reference nodes in step 4, more specifically, after the samples have been thermally treated, the location of the nodes are measured to determine their displacements in the *X* direction, *dx,* and *Y* direction, *dy.* The compaction value for each direction is the slope of the linear regression of displacement as a function of location:

$$X - Direction\ Compaction = \frac{\sum_{i=1}^{72}(x_i - 132)(dx_i - \overline{dx})}{\sum_{i=1}^{72}(x_i - 132)^2} \qquad \textbf{Eq. (1)}$$

$$Y - Direction\ Compaction = \frac{\sum_{i=1}^{72}(y_i - 132)(dy_i - \overline{dy})}{\sum_{i=1}^{72}(y_i - 132)^2} \qquad \textbf{Eq. (2)}$$

where *i* is a subscript identifying a measurement node, *x* and *y* specify the coordinates of each node; and *dy* and *dx* are direction specific displacements of each node relative to the initial measurement. The value 132 in the equations above is the mean value of both *x* and *y*. The *X* and *Y* direction compactions are averaged to obtain the compaction values.

In general, the QCOLED compaction magnitude decreases continuously with increasing anneal point of a particular glass material. Accordingly, heat-treating a glass material, as a carrier that goes through a process for forming electronic devices on a thin sheet coupled thereto, may have its QCOLED value decreased whereby it will behave like a higher anneal point glass in a subsequent process.

Process for Reusing a Carrier

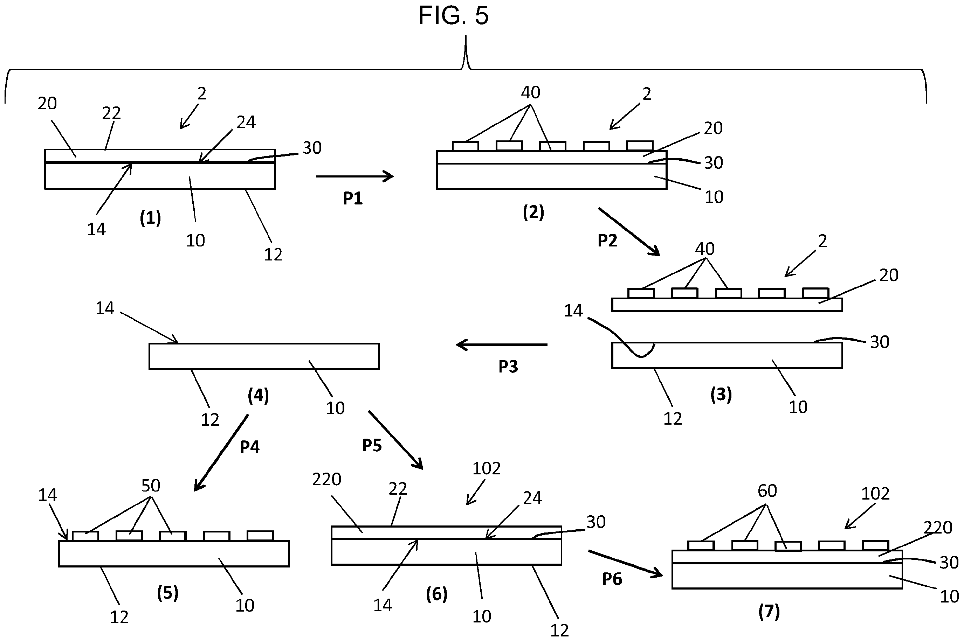

One manner of reusing the carrier 10 will be described in connection with FIG. 5. Before the article 2 enters a process P1, as at (1), it includes a thin sheet 20 coupled to a carrier 10 by a coupling agent 30. Throughout FIGS. 5-7, for sake of convenience, the coupling agent is shown as having no thickness, however, again, it is not drawn to scale. At this stage, the article as a whole has a first QCOLED compaction value, as does each of its component parts, the carrier 10, and the thin sheet 20 The thin sheet compaction might range from 50 ppm to 250 ppm while the thick sheet (or carrier 10) compaction might range from 20 ppm to 150 ppm depending on their chemical composition and thermal process used to fabricate them.

The article 2 is then subjected to the process P1, as schematically represented by an arrow, so as to form first devices 40 on the thin sheet 20, the result of which is shown at (2). The process P1 may include various steps having various time-temperature cycles, and a maximum temperature.

The process P1 may include processing of the article at a temperature of greater than 250°C and ≤ 450°C when the devices 40 are amorphous oxide TFTs, amorphous IGZO devices, or parts of an amorphous silicon backplane of a display device, for example, an OLED or LCD display panel

Alternatively, the process P1 may be a low-temperature poly silicon process, i.e., low temperature compared with solid phase crystallization which includes temperatures of around 750°C. Thus, a low-temperature poly silicon process actually includes processing temperatures in a range of from greater than 450°C to ≤ 700°C. This process may include eximer laser anneal (ELA), rapid thermal anneal (RTA), or other steps to form a low-temperature poly silicon device, or a crystalline oxide TFT device. These types of devices may be used in hand held flat panel display devices.

After the article 2 has finished the processing of P1, it will have a second QCOLED compaction value that is less than the first QCOLED compaction value. Again, this will also be true for each of the component parts of the article 2, i.e. the carrier 10 and thin sheet 20 will each have a second QCOLED compaction value lower than their respective first QCOLED compaction value. The article 2 then undergoes a process P2, as schematically shown by an arrow, to separate the thin sheet 20 (either as a whole, or portions thereof) having devices 40 thereon from carrier 10. The result of process P2 is shown at (3). The coupling agent 30 may be designed to stay with the carrier 10, as shown, during the separation; alternatively, the coupling agent 30 may be designed to stay with the thin sheet 20. In any event, the process P2 is one that is capable of removing the thin sheet 20 from the carrier 10 without damage to the bonding surface 14 of the carrier.

In the event that the coupling agent 30 stays with the carrier 10 after separation of the thin sheet 20, the carrier 10 then goes through process P3 to remove the coupling agent 30 therefrom. The result of process P3 is shown at (4). Depending upon the material of the coupling agent 30, it may be removed from the carrier 10 by washing, heating, plasma cleaning, standard cleaning (SC1 or SC2), RCA cleaning, and/or piranha cleaning, for example.

After the coupling agent 30 is removed-either by process P2 or by process P3 as appropriate-the carrier 10 is then ready for further processing. In some instances, the carrier 10 may be used as a substrate on which there are formed second devices 50 by process P4, shown schematically by an arrow. The result of process P4 is shown at (5), wherein the second devices 50 are formed on the bonding surface 14 of the carrier 10.

The process P4 may be a process having a temperature range other than that used during process P1.

The maximum processing temperature in process P4 may be less than that in process P1. For example, when process P1 includes maximum processing temperatures in the range of greater than 250°C and $\leq$ 450°C, as noted above, then process P4 may have a lower maximum processing temperature range, i.e., $\leq$ 250°C as when the second devices 50 are color filters or touch sensors including a transparent conductive material, for example, indium-tin-oxide (ITO). In this case the reduction in the QCOLED compaction value of the carrier 10 resulting from process P1 will form a substrate 10 that is suitable for forming devices 50 at a lower temperature without undergoing any substantial additional compaction during the process P4, wherein a compaction change of $\leq$ 5% is not substantial.

Alternatively, the maximum processing temperature in process P4 may be higher than that in P1. For example, when process P1 includes maximum processing temperatures in the range of greater than 250°C and $\leq$ 450°C, as noted above, then process P4 may have a higher maximum processing temperature range, i.e., from greater than 450°C to $\leq$ 700°C as when the second devices 50 are low temperature poly-silicon devices, or crystalline oxide TFT devices as are suited for hand-held FPDs. In this case the reduction in the QCOLED compaction value of the carrier 10 resulting from process P1 will form a substrate 10 that is suitable for forming devices 50 at a higher temperature without undergoing any substantial additional compaction during the process P4. That is, the process P1 will "anneal" the carrier 10 so that it is suited for higher temperature processing.

In one embodiment, the carrier may be made from a chemically strengthenable glass, wherein prior to process P4, the carrier is chemically strengthened. The devices in process P4 may then be any one or more of an anti-glare, anti-fingerprint, anti-smudge, or anti-microbial, film.

Instead of using the carrier 10 as a substrate for second electronic devices 50, it may again be used as a carrier 10 in a second article 102 having a second thin sheet 20. In this case, instead of going through process P4, the carrier may go through a process P5 to couple thereto a second thin sheet 220 by a coupling agent 30. In some instances, the coupling agent 30 may be left on the carrier 10 after process P2 and, thus, a removing process P3 may not be necessary. Alternatively, the coupling agent 30 as at (3) may be removed via process P3, and new coupling agent 30 may be used in process P5 to couple the second thin sheet 220 to the carrier 10. The result of process P5 is shown at (6), wherein a second article 102 includes a second thin sheet 220 coupled to the carrier 10 by coupling agent 30.

The second article 102 may then go through a process P6 to form third devices 60 on the second thin sheet 220. The result of process P6 is shown at (7). The particulars of process P6 may be similar to those set forth above with respect to process P4, except that the electronic devices are formed on second thin sheet 220 instead of on the carrier 10. After process P6, the second thin sheet 220 is removed from the carrier in a manner similar to that described above in connection with process P2. From there, the carrier 10 may be reused again in the manner as explained above regarding processes P3 and P4 to form electronic devices 50 on the bonding surface of the carrier 10. Alternatively, if the prior processing of the carrier 10 provides the carrier with a QCOLED compaction value such that it is "dead annealed" with respect to the temperatures in the process P6 (i.e., it will undergo a change in compaction of $\leq$ 5%), then the carrier 10 may be used again and again to repeatedly carry second thin sheets 220 to form third devices 60 thereon. However, the repeated use of carrier 10 through process P6 in this instance is likely to lead to the degradation of the carrier 10 in terms of its optical clarity or mechanical strength as by scratching in the processing equipment. Accordingly, there is a practical limit to the number of times a carrier 10 may be reused and, therefore, it may be more advantageous in certain instances to simply reuse the carrier 10 as a substrate onto which there are formed electronic devices 50 as by process P4 described above.

Alternative Article Configuration

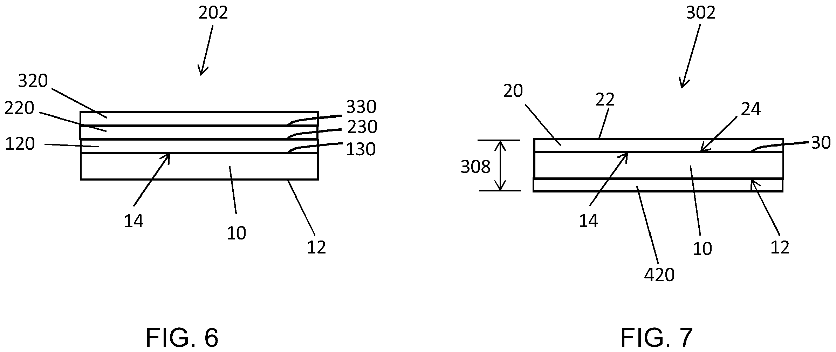

A second embodiment of an article will be explained in connection with FIG. 6. In this embodiment, mainly the differences from the first embodiment of FIGS. 1, 2, and 5 will be described, with the understanding that the remaining elements are similar to those described in connection with the first embodiment, and wherein like reference numerals denote like elements throughout the embodiments.

In this embodiment, an article 202 includes a carrier 10 that has a first thin sheet 120 coupled thereto by a first coupling agent 130. In turn, the first thin sheet 120 has a second thin sheet 220 coupled thereto by a second coupling agent 230, and the second thin sheet 220 has a third thin sheet 320 coupled thereto by a third coupling agent 330. Each of the coupling agents 130, 230 and 330, may be the same as described above in connection with the coupling agent 30. Further, each of the coupling agents 130, 230, 330, may be the same material or may be different materials, depending upon the circumstances. The thickness of the article 202 will be a sum of the thicknesses of its components.

When first assembled, the article 202 will include a first QCOLED compaction value, as will each of its component parts, i.e., carrier 10, first thin sheet 120, second thin sheet 220, and third thin sheet 320. The article 202 may be processed to form electronic devices successively on third thin sheet 320, second thin sheet 220, and first thin sheet 120. After processing electronic devices on one thin sheet, that thin sheet may be peeled from the article 202 so as to allow access to the surface of the next thin sheet below, similar to the manner in which processes P1 and P2 were explained above, whereby the article may have a second QCOLED compaction value after the process P1 (again, as will each of its component parts, carrier 10, first thin sheet 120, and second thin sheet 220), wherein the second QCOLED compaction value is less than the first QCOLED compaction value. After peeling of the one thin sheet, the surface of the next thin sheet may undergo a process to remove any coupling agent therefrom. In such a manner, electronic devices may be successively formed on successive thin sheets in the article 202, as long as the subsequent processes are carried out in equipment designed to process an article having a QCOLED compaction value resulting from the prior processes. When processing electronic devices in such a manner, it is advantageous when the successive processes occur at lower and lower temperatures so as to avoid excessive change in the QCOLED values of the carrier 10 and any remaining thin sheets coupled thereto. In another advantageous embodiment, the carrier 10 may be "dead annealed" prior to coupling the thin sheets 120, 220 ,320, thereto, so as to reduce the change in QCOLED compaction value of the article 202 as it undergoes successive processing, whereby electronic devices may reliably be made on each successive thin sheet 320, 220 120. For example, low temperature poly silicon devices may be processed on third thin sheet 320, then amorphous oxide TFT devices (or amorphous IGZO devices, or amorphous silicon LCD backplane devices) may be processed on second thin sheet 220, and finally touch sensor or color filter devices may be formed on first thin sheet 120.

Although three thin sheets 120, 220, 320, are shown as being coupled to the carrier 10, any suitable number of thin sheets may be used, for example, 2, 4, 5, 6, 7, 8, 9, 10.

Alternative Article Configuration

A third embodiment of an article will be explained in connection with FIG. 7. In this embodiment, mainly the differences from the first and second embodiments will be described, with the understanding that the remaining elements are similar to those described in connection with the first and second embodiments, and wherein like reference numerals denote like elements throughout the embodiments.

Article 302 includes a thin sheet 20 coupled to a carrier 10 by a coupling agent 30. Additionally, the carrier 10 includes a protective layer 420 on a side thereof opposite to that on which the thin sheet 20 is coupled. The thickness 308 of the article 302 is the sum of thicknesses of its component parts. The protective layer 420 may be an additional thin sheet coupled to the carrier by a coupling agent 30, or may be a hard coat layer, a layer of transparent conductive material, or ITO, for example. The purpose of the protective layer 420 is to protect (as from scratching or other damage, for example) the first surface 12 of the carrier 10 when electronic devices are being processed onto the first surface of the thin sheet 20. The protective layer 420 may be removed, as necessary, in the event that the carrier is used as a substrate on which electronic devices are formed, for example. In some instances, as when protective layer 420 is a thin sheet of a similar material having properties similar to those of thin sheet 20, the use of a thin sheet as protective layer 420 may minimize warping of the article 302.

It should be noted that the protective layer 420 disclosed in connection with the third embodiment may be used in the first and second embodiments in a similar fashion.

It should be emphasized that the above-described embodiments of the present invention, particularly any "preferred" embodiments, are merely possible examples of implementations, merely set forth for a clear understanding of various principles of the invention. Many variations and modifications may be made to the above-described embodiments of the invention without departing substantially from the scope of the present defined by the following claims.

**Claims**

1. Method of processing electronic devices comprising:

   obtaining a first article comprising a first thin glass sheet (20) coupled to a carrier (10), wherein the carrier has a first QCOLED compaction value;
   subjecting the first article to a first processing cycle (P1) to form a first device (40) on the first thin glass sheet (20), wherein the first processing cycle comprises heat treating the carrier, so that after the first processing cycle, the carrier has a second QCOLED compaction value that is less than the first QCOLED compaction value, wherein the QCOLED compaction values are measured according to the method described at paragraphs [0059]-[0060] of the description;
   removing the first thin glass sheet (20) from the carrier (10); and
   subjecting the carrier (10) to a second processing cycle (P4, P6), to form a second device (50, 60) on the carrier **characterised in that** the second processing cycle is different to the first processing cycle (P1).

2. The method of claim 1, wherein the carrier is chemically strengthened prior to the second processing cycle, and further wherein the second device includes an anti-glare, anti-fingerprint, anti-smudge, or anti-microbial, film.

3. The method of claim 1 further comprising, after removing the first thin glass sheet (20) from the carrier, coupling the carrier to a second thin glass sheet (220) to form a second article (102); and
   subjecting the second article to the second processing cycle to form a second device (60) on the second thin glass sheet (220), wherein after the second processing cycle (P6) the carrier QCOLED compaction value decreases ≤ 5%.

4. The method of claim 1 wherein the first article (202) comprises a second thin glass sheet (120) coupled to the first thin glass sheet (220) and to the carrier (10), and further comprising after removing the first thin glass sheet (220) from the carrier so as to form a second article comprising the second thin glass sheet (120) and the carrier, subjecting the second article to a second processing cycle to form a second device on the second thin glass sheet (120).

5. The method of claim 4, wherein the carrier is dead-annealed.

6. The method of claim 4, wherein the second thin glass sheet is located on the same side of the carrier as is the first thin glass sheet.

7. The method of any one of claims 1-6, wherein during the second processing cycle a maximum processing temperature used is less than that used during the first processing cycle.

8. The method of any one of claims 1-7, wherein the first processing cycle includes a maximum temperature in the range of greater than 450°C to ≤ 700°C.

9. The method of any one of claims 1-6, wherein the second processing cycle maximum temperature is greater than that in the first processing cycle.

10. The method of any one of claims 1-9, further comprising providing a protective layer on a side of the carrier opposite to that on which the thin glass sheet is located during processing.


**Patentansprüche**

1. Verfahren zum Verarbeiten von elektronischen Vorrichtungen, beinhaltend:

   Erhalten eines ersten Artikels, beinhaltend eine erste dünne Glastafel (20), die an einen Träger (10) gekoppelt ist, wobei der Träger einen ersten QCOLED-Verdichtungswert aufweist;
   Unterziehen des ersten Artikels einem ersten Verarbeitungszyklus (P1), um eine erste Vorrichtung (40) auf der ersten dünnen Glastafel (20) zu bilden, wobei der erste Verarbeitungszyklus Wärmebehandeln des Trägers beinhaltet, sodass nach dem ersten Verarbeitungszyklus der Träger einen zweiten QCOLED-Verdichtungswert aufweist, der niedriger als der erste QCOLED-Verdichtungswert ist, wobei die QCOLED-Verdichtungswerte gemäß dem in den Absätzen [0059]-[0060] der Beschreibung beschriebenen Verfahren gemessen werden;

Entfernen der ersten dünnen Glastafel (20) vom Träger (10); und

Unterziehen des Trägers (10) einem zweiten Verarbeitungszyklus (P4, P6), um eine zweite Vorrichtung (50, 60) auf dem Träger bilden, **dadurch gekennzeichnet, dass** sich der zweite Verarbeitungszyklus vom ersten Verarbeitungszyklus (P1) unterscheidet.

2. Verfahren gemäß Anspruch 1, wobei der Träger vor dem zweiten Verarbeitungszyklus chemisch gestärkt wird und wobei ferner die zweite Vorrichtung eine Antireflex-, Antifingerprint-, Antischmier- oder Antimikrobenfolie umfasst.

3. Verfahren gemäß Anspruch 1, ferner beinhaltend, nach dem Entfernen der ersten dünnen Glastafel (20) vom Träger, Koppeln des Trägers an die dünne Glastafel (220), um einen zweiten Artikel (102) zu bilden; und Unterziehen des zweiten Artikels dem zweiten Verarbeitungszyklus, um eine zweite Vorrichtung (60) auf der zweiten dünnen Glastafel (220) zu bilden, wobei nach dem zweiten Verarbeitungszyklus (P6) der QCOLED-Verdichtungswert des Trägers $\leq 5\ \%$ abnimmt.

4. Verfahren gemäß Anspruch 1 wobei der erste Artikel (202) eine zweite dünne Glastafel (120) beinhaltet, die an die erste dünne Glastafel (220) und an den Träger (10) gekoppelt ist, und ferner beinhaltend, nach dem Entfernen der ersten dünnen Glastafel (220) vom Träger, um so einen zweiten Artikel zu bilden, der die zweite dünne Glastafel (120) und den Träger beinhaltet, Unterziehen des zweiten Artikels einem zweiten Verarbeitungszyklus, um eine zweite Vorrichtung auf der zweiten dünnen Glastafel (120) zu bilden.

5. Verfahren gemäß Anspruch 4, wobei der Träger weichgeglüht wird.

6. Verfahren gemäß Anspruch 4, wobei sich die zweite dünne Glastafel auf der gleichen Seite des Trägers befindet wie die erste dünne Glastafel.

7. Verfahren gemäß einem der Ansprüche 1-6, wobei während des zweiten Verarbeitungszyklus eine verwendete maximale Verarbeitungstemperatur niedriger als jene ist, die während des ersten Verarbeitungszyklus verwendet wird.

8. Verfahren gemäß einem der Ansprüche 1-7, wobei der erste Verarbeitungszyklus eine maximale Temperatur im Bereich größer als 450 °C bis ≤700 °C beinhaltet.

9. Verfahren gemäß einem der Ansprüche 1-6, wobei die maximale Verarbeitungstemperatur des zweiten Verarbeitungszyklus größer als jene im ersten Verarbeitungszyklus ist.

10. Verfahren gemäß einem der Ansprüche 1-9, ferner beinhaltend Bereitstellen einer Schutzschicht auf einer Seite des Trägers gegenüber der, auf der sich die dünne Glastafel während der Verarbeitung befindet.

**Revendications**

1. Procédé de traitement de dispositifs électroniques comprenant :

l'obtention d'un premier article comprenant une première plaque en verre mince (20) couplée à un support (10), ledit support possédant une première valeur de compactage QCOLED ;

la soumission du premier article à un premier cycle de traitement (P1) afin de former un premier dispositif (40) sur la première plaque en verre mince (20), ledit premier cycle de traitement comprenant le traitement thermique du support, afin qu'après le premier cycle traitement, le support possède une seconde valeur de compactage QCOLED qui est inférieure à la première valeur de compactage QCOLED, lesdites valeurs de compactage QCOLED étant mesurées selon le procédé décrit aux paragraphes [0059] et [0060] de la description ;

le retrait de la première plaque en verre mince (20) du support (10) ; et

la soumission du support (10) à un second cycle de traitement (P4, P6) afin de former un second dispositif (50, 60) sur le support **caractérisé en ce que** le second cycle de traitement est différent du premier cycle de traitement (P1).

2. Procédé selon la revendication 1, ledit support étant chimiquement renforcé avant le second cycle de traitement, et en outre ledit second dispositif comprenant un film antireflet, anti-empreintes digitales, anti-salissures, ou anti-microbien.

3. Procédé selon la revendication 1, comprenant en outre, après avoir retiré la première plaque en verre mince (20) du support, le couplage du support à une seconde plaque en verre mince (220) pour former un second article (102) ; et la soumission du second article au second cycle de traitement pour former un second dispositif (60) sur la seconde plaque en verre mince (220), après le second cycle de traitement (P6) la valeur de compactage QCOLED du support diminue ≤ 5 %.

4. Procédé selon la revendication 1, ledit premier article (202) comprenant une seconde plaque en verre mince (120) couplée à la première plaque en verre mince (220) et au support (10) et comprenant en outre, après avoir retiré la première plaque en verre mince (220) du support de façon à former un second article comprenant la seconde plaque en verre mince (120) et le support, la soumission du second article au second cycle de traitement afin de former un second dispositif sur la seconde plaque en verre mince (120).

5. Procédé selon la revendication 4, ledit support étant adouci.

6. Procédé selon la revendication 4, ladite seconde plaque en verre mince étant située sur le même côté que le support tout comme l'est la première feuille de verre mince.

7. Procédé selon l'une quelconque des revendications 1 à 6, durant le second cycle de traitement une température maximale de traitement utilisée étant inférieure à celle utilisée durant le premier cycle de traitement.

8. Procédé selon l'une quelconque des revendications 1 à 7, ledit premier cycle de traitement comprenant une température maximale comprise dans la plage supérieure à 450°C et inférieure ou égale à 700°C.

9. Procédé selon l'une quelconque des revendications 1 à 6, ladite température maximale du second cycle de traitement étant supérieure à celle du premier cycle de traitement.

10. Procédé selon l'une quelconque des revendications 1 à 9, comprenant en outre la disposition d'une couche protectrice sur un côté du support opposé à celui sur lequel se trouve la plaque en verre mince durant le traitement.

FIG. 1

FIG. 2

EP 2 974 534 B1

FIG. 3

FIG. 4

# FIG. 5

EP 2 974 534 B1

202

320
220
120

330
230
130

14

10

12

FIG. 6

302

20    22    24
                    30

308

14    10    12

420

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61736887 A
- US 61736862 B
- US 61736871 B
- US 1325035 W
- WO 2005048669 A
- WO 2010129459 A